# EUROPEAN PATENT APPLICATION

(11) **EP 1 396 866 A1**
(43) Date of publication of application: **10.03.2004**
(21) Application number: 02736052.8
(22) Date of filing: 11.06.2002
(51) Int. Cl.: H01B 12/04, H01B 13/00, H01F 6/00

(54) **SUPERCONDUCTING WIRE MATERIAL AND METHOD FOR PREPARATION THEREOF AND SUPERCONDUCTING MAGNET USING THE SAME**

(30) Priority: 15.06.2001 JP 2001180990
(71) Applicant: Hitachi, Ltd., Chiyoda-ku, Tokyo 101-8010 (JP)
(72) Inventor: TANAKA, Kazuhide, Hitachi-shi, Ibaraki 319-1225 (JP); OKADA, Michiya, Ibaraki 311-1134 (JP); MORITA, Hiroshi, Ibaraki 310-0852 (JP); SUZUKI, Yasuo, Takahagi-shi, Ibaraki 318-004 (JP)
(74) Representative: Beetz & Partner Patentanwälte
(86) International application number: PCT/JP2002/005814
(87) International publication number: WO 2002/103716

(57) **Abstract**

An object of the present invention is to provide: a superconducting wire with a boron-containing superconductor charged or included therein, the superconducting wire further being able to have a practical critical current density; a method for manufacturing the superconducting wire, and; a superconducting magnet using the superconducting wire.

The present invention is characterized in that: in a superconducting wire which has a boron-containing superconductor charged or included therein, a metal-sheathing material made of either a single metal selected from a group consisting of gold, silver, aluminum, copper, iron, platinum, palladium, nickel, stainless steel, chromium, magnesium, tantalum, niobium, titanium, tin, beryllium, tungsten, and cobalt, or an alloy consisting of a plurality of metals selected from this group, is disposed on the outer surface of the foregoing superconducting wire, the density of the superconducting wire after it has been finally processed is 80% or more of its theoretical density, and the critical temperature of the superconducting wire is 30K or more.

## Description

### [Field of the Invention]

The present invention relates to: a superconducting wire that enables high superconducting critical current density to be obtained by using a superconductor which develops superconductivity under an environment not exceeding the critical temperature of the superconductor; a method for manufacturing the foregoing superconducting wire, and; a superconducting magnet using the superconducting wire. More specifically, the present invention is applied to equipment such as electric current leads, electric power transmission cables, large-size magnets, nuclear magnetic resonance analyzing apparatus, magnetic resonance diagnosing apparatus for medical use, superconducting power storage units, magnetic separators, magnetic-field-applied single-crystal pull-up apparatus, refrigerator-cooled superconducting magnet apparatus, superconduction energy storage units, superconducting power generators, and magnets for nuclear fusion reactors.

### [Related Art]

Metallic superconducting materials such as NbTi and Nb₃Sn, are known as conventional superconducting materials. These metal -based superconducting materials, however, have had the problem that since their critical temperatures are up to 23K (Kelvin) even in the case of Nb₃Ge, expensive liquid helium must be used for cooling.

Referring to high-temperature superconductors, since April 1986, in which oxide-based superconductors containing lanthanum (La) whose critical temperature is 30K were discovered, copper-based oxide superconductors, such as yttrium (Y), bismuth (Bi), thallium (TI), or mercury (Hg), that exceed the boiling temperature of 77K of liquid nitrogen in terms of critical temperature have been discovered in rapid sequence. In these copper-containing oxides, however, there has been the disadvantage that because of their ceramic composition, they are difficult to process and cannot be easily drawn into a linear shape.

Recently, it has been found that as reported in "Nature 410, 63-64 (2001)", magnesium diboride (MgB₂) exhibits superconductivity at approximately 40K. Since MgB₂ is higher than metal-based superconducting materials in terms of critical temperature, future application of this material to automobiles and the like will increase the demand for the material, hereby enabling the use of liquid hydrogen regarded as significantly inexpensive in comparison with liquid helium. Magnesium diboride can also be easily obtained, and in addition, since it consists of the magnesium (Mg) and boron (B) that are low in raw materials cost, MgB₂ is relatively easy to roll out into a thinner material and to bend. Furthermore, MgB₂ is classified as a very attractive material in terms of manufacturing costs since wires can be manufactured with the "powder-in-tube" method that is usually used when oxide superconducting wires are manufactured.

From these reasons, not only the use of MgB₂ in electric power applications such as power transmission cables, but also the contribution of this material in various fields such as bio-science, which is one of the fields highlighted in recent years, can be anticipated, provided that practical superconducting characteristics become maintainable with an MgB₂ wire.

There is the problem, however, that compared with conventional metal-based and oxide-based superconductors, the MgB₂-based superconducting wires that have been test-produced up to now are, at present, extremely low in critical current density, upper critical magnetic field intensity, and irreversible magnetic field intensity. For example, as described in "Nikkei Mechanical News", Issue No. 870, published on February 28, the critical current densities in conventional MgB₂-based superconducting wires are up to approximately 100,000 A/cm² under the conditions of 5K in temperature and 1T in magnetic field intensity, and up to approximately 40,000 A/cm² at a temperature of 20K and a magnetic field intensity of 1T. Accordingly, the critical current densities in these conventional superconducting wires need to be improved by the order of about one digit to allow for their practical use.

Therefore, studies towards synthesizing MgB₂ under high pressure or towards accelerating the single-phase structuring of MgB₂ have been energetically conducted in order to solve the problems described above. However, an MgB₂-based superconducting wire with a practical critical current density, upper critical magnetic field intensity, and irreversible magnetic field intensi ty, has not been obtainable heretofore.

### [Disclosure of the Invention]

The present invention was made in consideration of the situations described above, and an object of the invention is to provide: a superconducting wire with a boron-containing superconductor charged or included therein, the superconducting wire further being able to have a practical critical current density even in a magnetic field; a method for manufacturing the superconducting wire, and; a superconducting magnet using the superconducting wire.

The present inventors have heretofore conducted research and development activities intended primarily to apply oxide superconducting wires and magnets using the same. During these activities, the inventors have found it to be important to achieve the following four items, in particular, as improvement items relating to critical current density: (1) selecting a metal-sheathing material not thermally reacting to a superconductor, (2) the charging density of a superconductor when it is processed to take its final shape, (3) improving intercrystalline bonding characteristics, and (4) introducing the pinning center that traps quantized magnetic lines of flux and immobilizes each of the magnetic lines of flux.

A superconducting wire that has excellent characteristics can be obtained by achieving the above four items at the same time. However, critical current density is not the characteristic value of the substance and depends greatly on its preparation method. It has been found that for this reason, critical current density cannot be improved too significantly with just any of the methods which have been applied to oxide superconducting wires or conventional metal-based superconducting wires. Accordingly, each material requires specific quantitative optimization, and a boron-containing superconductor has also come to require its own study.

As a result of focusing their research activities on solving the above problems, the present inventors have discovered: a unique superconducting wire capable of being greatly improved in superconductivity, compared with conventional superconducting wires and superconducting magnets; a method for manufacturing the new superconducting wire mentioned above, and; a superconducting magnet using the superconducting wire. The present invention is summarized below.

That is to say, the object described above can be accomplished by creating a superconducting wire having a boron-containing superconductor charged or included therein; wherein a metal-sheathing material made of either a single metal selected from a group consisting of gold, silver, aluminum, copper, iron, platinum, palladium, nickel, stainless steel, chromium, magnesium, tantalum, niobium, titanium, tin, beryllium, tungsten, and cobalt, or an alloy consisting of a plurality of metals selected from this group, is disposed on the outer surface of the foregoing superconducting wire, the density of the superconducting wire after it has been finally processed is 80% or more of its theoretical density, and the critical temperature of the superconducting wire is 30K or more.

Also, the foregoing superconducting wire can be realized by adding metal powder lower than the superconducting wire in terms of fusion point, to the superconductor included in the superconducting wire.

In addition, the above-described superconducting wire can be realized by using, as the element of the above-mentioned metal powder to be added to the superconducting wire, either a single metal selected from a group consisting of indium, lead, gold, silver, magnesium, and aluminum, or a mixture consisting of a plurality of metals selected from this group.

Furthermore, when the average crystal grain size, S, in the above-described superconducting wire and the average grain size, M, of the above-mentioned metal powder are maintained in the relationship of S ≥ M, the effect obtained therefrom is extremely great. Besides, provided that the average crystal grain size in the superconducting wire is 20 microns or less, critical current density can be improved further.

Furthermore, the above-described superconducting wire can be realized by creating a superconducting wire in which the amount of addition of the metal powder mentioned above is 50% or less of the superconductor in terms of weight percentage.

A method for manufacturing the above-described object can be accomplished by providing: a first process in which superconductors that contain boron are to be synthesized into a single superconductor; a second process in which the superconductor that was prepared in the foregoing first process is to be charged into or included in a metal-sheathing material made of either a single metal selected from a group consisting of gold, silver, aluminum, copper, iron, platinum, palladium, nickel, stainless steel, chromium, magne sium, tantalum, niobium, titanium, tin, beryllium, tungsten, and cobalt, or an alloy consisting of a plurality of metals selected from this group, and; either a third process in which a wire that was prepared in the foregoing second process is to be diametrally reduced for a cross-sectional area reduction ratio of at least 10% of its original value, or a fourth process in which the foregoing wire is to be deformed by applying a pressure of at least 1 ton/cm², or both of the foregoing third and fourth processes.

Also, the above-described third or fourth process of the superconducting wire manufacturing method described above can be implemented by increasing temperature to a region exceeding the temperature at which a portion of either the superconductor included in the superconducting wire or the metal powder added thereto, or portions of both the superconductor and the metal powder begin to fuse. In this case, there is the advantage that during the manufacturing processes for the superconducting wire, no heating is required for this wire.

In addition, the first process of the superconducting wire manufacturing method can be implemented by adopting fluoride as a raw material. The authors have experimentally confirmed that this is because, during the synthesis of superconductors, the diffusion of fluorine accelerates the single-phase structuring of the superconductors.

Furthermore, a superconducting magnet that uses the superconducting wire prepared by means of the superconducting wire manufacturing method described above and has a permanent current switch whose wires are wound into coil form, can be realized as a permanent current magnet by configuring the superconducting magnet so that the electrical resistance across the magnet is controlled to small enough a value for this magnet to function as a permanent current magnet. In this case, in the superconducting magnet formed by combining different types of superconductors, a much greater effect can be obtained by using, at the connections between these superconductors, the superconducting wire that has been prepared using the superconducting wire manufacturing method described above. More specifically, it is preferred that the superconducting wire according to the present invention should be used in a crimped condition at the connections between a plurality of superconductors, and hereby, the resistance across the above-described superconducting magnet can be reduced by the order of one to four digits.

Also, a superconducting magnet whose mechanical strength is high enough for the superconducting magnet to hold the electromagnetic force applied thereto can be a ferromagnetic-field-generating superconducting magnet. In this case, a much greater effect can be obtained by using, as the insulating material to be wound together with the superconducting wire, either a 0.1%-20.0% aluminum-containing copper alloy, stainless steel, titanium alloy, iron-based heat-resistant alloy, nickel-based heat-resistant alloy, or cobalt-based heat-resistant alloy, or a combination consisting of a plurality of metals selected from this group.

Methods of manufacturing the superconducting powder, sintered body, and bulk pertaining to the present invention, include a method in which the respective compounds are to be crushed and mixed and then the resulting mixture is to be burned. This method may be one by which all raw compound materials are to be mixed at the same time, or by which some of the raw compound materials are to be mixed beforehand and then the remaining raw powder is to be mixed.

Heat-treating temperatures from 600 to 1,200 degrees C are used to synthesize the superconducting powder materials in the present invention. Also, this heat-treating process uses, as required, a single gas such as an oxygen gas, nitrogen gas, or argon gas, or a mixture of these gases. In addition, the heat-treating process is conducted under a pressure equal to, or greater than, an atmospheric pressure, as required.

A number of methods of preparing a superconducting wire have been proposed up to now. In this Specification, the powder-in-tube method is described in detail below as one such example.

After superconductors or precursors have been synthesized in the way as set forth above, the resulting product is crushed and sintered to a suitable size and then this sintered body is charged into a pipe-like metal-sheathing material. This metal-sheathing material consists of either gold, silver, aluminum, copper, iron, platinum, palladium, nickel, stainless steel, chromium, magnesium, tantalum, niobium, titanium, tin, beryllium, tungsten, or cobalt alone, or of a plurality of metals selected from this group. Of course, it is necessary for the metal-sheathing material not to thermally react to superconductors, and in addition, it needs to be highly processable to allow for mass production.

Furthermore, to use a multi-filamentary wire, a plurality of metal-sheathing materials are to be arranged, and these sheathing materials can differ in characteristics such as type. In that case, when each sheathing material is to be double-structured, although inner and outer metal-sheathing materials not thermally reacting to superconductors are preferred, it is further preferred that the outer metal-sheathing material should not only have resistance to the above reaction, but also be high in strength. Hereby, there is the advantage that the sheathing material can also function as a reinforcing material. Also, the formation of an insulating film, such as an oxide film, on the surface of this metal further enables it to function as an insulating material.

The diameter of the wire can be reduced by repeating wire-drawing at a cross-sectional area reduction ratio of about 1%-20% per pass, by use of a draw bench, a swager, a cassette roller die, or grooved rolls. The wire may be constructed into multi-filamentary form as required. When the wire is constructed into multi-filamentary form, a wire that has been drawn into a round cross-sectional shape or a hexagonal cross-sectional shape is built into a pipe and then the wire is further drawn to the required diameter at a cross-sectional area reduction ratio of about 1%-20% per pass, by use of the devices mentioned above. The processes here have not only the action that shapes the wire into the desired form, but also, at the same time, enhances the density of the superconducting powder charged into the metal-sheathing material. A wire higher in critical current density can be obtained by processing the wire into a square or tapered cross-sectional shape by use of a cold- or hot-rolling mill and then providing heat treatment at the appropriate temperature or under the appropriate atmosphere to achieve an even finer powder surface.

In the superconducting wire according to the present invention, high critical current density can be obtained when the density of the finally shaped superconductor exceeds 80% of its theoretical density.

Although a temperature from 600 to 1,200 degrees C is used as the final heat-treating temperature for the superconducting wire in the present invention, high critical current density can be obtained, even without heat treatment. The authors have experimentally confirmed that this is because high intercrystalline bonding characteristics can be obtained during the diametral reduction process and deforming process for the wire. However, heat treatment is valid for accelerating the single-phase structuring of the superconducting phases, and as the case may be, the acceleration of the single-phase structuring improves critical current density by nearly 10%. It has also been confirmed, however, that the crystal grain size of a superconductor that is suitable for improving critical current density is 20 microns or less, and that if this grain size range is exceeded, critical current density decreases.

After wires have thus been prepared, two or more wires are mixed and wound into a coil-like shape or molded into linear lead wire form or linear cable form, depending on the particular requirements, before the wires are actually used. When heat treatment is required, the appropriate heat-treating atmosphere for the particular material is selected to enhance the characteristics of the superconductor. For example, only a suitable amount of single gas such as an oxygen gas, nitrogen gas, or argon gas, or a suitable amount of mixture of these gases is either supplied as an air stream or sealed, and then used for heat treatment. Also, in MgB₂-based superconductors, since magnesium high in steam pressure may fly about during heat treatment and hereby cause the chemical composition disturbance that deteriorates superconducting characteristics, it is effective to conduct the heat treatment after creating a quasi-magnesium atmosphere by, for example, heat-treating a sintered magnesium body simultaneously with the superconducting wire. In addition, including magnesium in metal-sheathing materials also yields a similar effect.

Furthermore, the addition of metal powder whose fusion point is lower than that of the superconductor pertaining to the present invention improves intercrystalline bonding characteristics, thus providing higher critical current density. Besides, the added metal disperses into the crystal grain boundary of the superconductor and into the grains thereof, and hereby, pinning force can be enhanced. Although a material low in fusion point, for example, indium or lead is desirable as the element of the metal powder, this element can also include gold, silver, magnesium, or aluminum, and it is further desirable that the average crystal grain size of the metal powder should be 10 microns or less. This is due to the fact that since the added metal creates a non-superconducting layer, current path is shut off if the average crystal grain size of that metal is greater than 10 microns. Also, the authors have experimentally verified that neither too great an amount of metal powder added nor too small amount thereof is preferable and that the amount of metal powder added needs to be 50% or less of the superconductor in terms of weight percentage.

In addition, during the preparation of the wire according to the present invention, it is necessary to provide processing by which the final shape of the superconducting wire becomes at least 10% of its original shape in terms of cross-sectional area reduction ratio. The wire-drawing or wire-rolling process that reduces the cross-sectional area of the superconducting wire has the action that improves the density of the superconductor charged into the metal-sheathing material, as described earlier in this Specification. Furthermore, deforming the superconducting wire by applying a pressure of 1 ton/cm² or more also provides a similar effect. These processes improve critical current density since they improve intercrystalline bonding characteristics. Besides, the authors have experimentally made it clear that a portion of either the superconductor or the metal powder, or portions of both become fused and hereby intercrystalline bonding characteristics further improve during the diametral reduction or deformation process.

A method other than the one described above, for example, thermal spraying, the doctor blade method, dip coating, spray pyrolysis, the jelly roll method, or the like can be used to obtain equivalent superconducting characteristics.

Also, since the superconducting wire in the present invention is extremely high in mechanical strength such as the yield stress, tensile strength, and Young's modulus of the wire itself, a magnet can be constructed that has the ability to withstand the electromagnetic force developed when a strong magnetic field occurs. And a permanent current magnet can be realized by sufficiently reducing the resistance across the magnet.

When the superconducting magnet in the present invention is prepared, it is important that the insulating material wound together with the superconducting wire should be tightly wound for coil design purposes and hereby that the magnetic field occurring should be enhanced. It is preferable, therefore, that the thickness of an insulating layer should be controlled below 0.3 mm, and this insulating layer should be thinned down to a thickness less than, further preferably, 0.1 mm. Also, it is important that even after cooling to a cryogenic level, insulating performance, adhesion, strength, and heat resistance should all be high enough. It is desirable that the insulating material be either a 0.1%-20.0% aluminum-containing copper alloy, stainless steel, titanium alloy, nickel-based heat-resistant alloy, or cobalt-based heat-resistant alloy, or a combination consisting of a plurality of metals selected from this group.

If the superconductor that has been manufactured according to the present invention is to be used in liquid helium, such a superconducting magnet or practical conductor that generates an even stronger magnetic field can be realized by adopting the structure combined with a metal-based superconductor or an oxide superconductor. The metal-based superconductor at this time is either an NbTi-based alloy, an Nb₃Sn-based compound, an Nb₃Al-based compound, a V₃Ga-based compound, or a Chevrel-based compound, and as required, two or more types of magnets are arranged. It is desirable that the oxide superconductor at this time should be a superconductor based on either Y, Bi, TI, Hg, or Ag-Pb.

When the superconductor that has been manufactured according to the present invention is to be used in liquid hydrogen or liquid neon, such a superconducting magnet or practical conductor that has higher performance can be realized by combination with an oxide superconductor.

The superconducting wire that has thus been prepared can be used for electric power transmission cables, electric current leads, MRI apparatus, NMR apparatus, SMES apparatus, superconducting power generators, superconducting motors, magnetically levitated trains, electromagnetically propelled vessels of the superconducting type, superconducting voltage transformers, and superconducting current limiters, as well as for superconducting magnets. Also, the conductor into which the superconducting wire has been processed into the desired shape is deformed for use as a conductor such as a current lead or a cable, and then built thereinto. It is even more effective if the operating temperature of the conductor is above the temperature of the liquid hydrogen or liquid neon.

### [Brief Description of the Drawings]

Fig. 1 is a cross-sectional schematic view of a round superconducting wire according to the present invention;
Fig. 2 is a cross-sectional schematic view of a square superconducting wire according to the present invention;
Fig. 3 is a diagram showing the relationship between the applied magnetic field intensity and critical current density in a wire whose superconductor was changed in density;
Fig. 4 is a diagram showing an example of manufacturing process es for a superconducting wire of the present invention;
Fig. 5 is a cross-sectional schematic view of a superconducting wire manufactured according to the present invention;
Fig. 6 is a view showing an example of a superconducting magnet system of the present invention; and
Fig. 7 is a view showing another example of a superconducting magnet system of the present invention.

### [Description of the Preferred Embodiments]

The present invention is described below using embodiments. The invention, however, is not limited by these embodiments.

First, description is given of a superconducting wire manufacturing method according to the present invention. Magnesium powder (Mg: 99% pure) and amorphous boron powder (B: 99% pure) are used as the starting raw materials, and then both types of powder, after being weighed for the atomic mole ratio between the magnesium and the boron to become 1:2, are mixed over 10 to 60 minutes. Next, this mixture is heat-treated over 2 to 20 hours at a temperature from 700 to 1,000 degrees C, and hereby, an MgB₂ superconductor is prepared. At this time, a pressure of 100 MPa or more may be applied during the heat treatment.

After X-ray diffraction of the obtained powder, it has been found that the content of the MgB₂ superconductor is more than 95% in terms of strength ratio and that slight amounts of MgO and MgB₄ are included in addition to MgB₂.

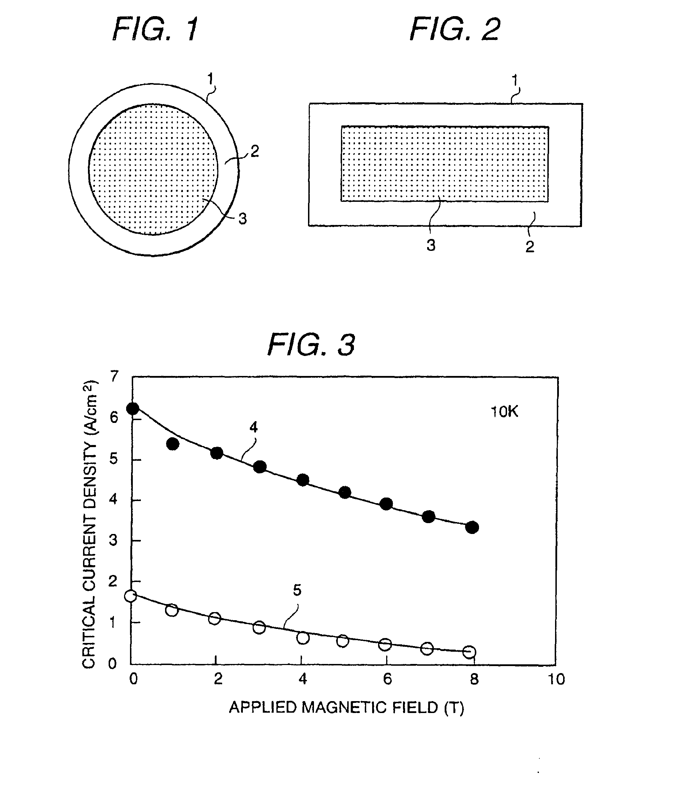

Next, the obtained powder is charged into an aluminum pipe which has a circular cross-sectional shape measuring 6 mm in outside diameter, 5 mm in inside diameter, and 500 mm in length. This wire material is then diametrally reduced to the required shape by being drawn at a cross-sectional area reduction ratio from 3% to 10%. In the present embodiment, such superconducting wires 1 as shown in Figs. 1 and 2 have been obtained by being diametrally reducing wire materials into a round wire about 2 mm in outside diameter and a square wire 1 mm long and 2 mm wide. Fig. 1 is a cross-sectional schematic view of the round wire, and Fig. 2 is a cross-sectional schematic view of the square wire. Both of the superconducting wires 1 have a superconductor 3 charged or included in respective metal -sheathing materials 2. Although both the two types of wires here are of monofilamentary structure, multi-filamentary wires can also be prepared as required.

In the present embodiment, two types of superconducting wires have been prepared: type A that has been heat-treated over 2 to 20 hours at a temperature from 700 to 1,000 degrees C, and type B that has only been diametrally reduced and has not been heat-treated.

Although, for practical purposes, it is desirable that round, oval, rectangular, and hexagonal wires should have an outside diameter from about 1 to 2 mm at the section smallest in the length of the opposite side, this outside diameter needs only to be changed to the appropriate value according to the particular requirements or energizing current and is not limited to the values mentioned above.

Next, the cross sections of the superconducting wires A and B prepared in the present embodiment have been observed using a scanning electron microscope. As a result, it has been confirmed that the average crystal grain sizes in the superconducting wires A and B are 12 microns and 7 microns, respectively. The critical temperatures of these wires have been measured with the direct-current four-terminal method to verify that the electrical resistance values of both become zero at 39K. Also, the critical current densities under the conditions of 10K in temperature and 1 T in magnetic field intensity have been measured and a value of 6 × 10⁴A/cm² for the superconducting wire A and a value of 5.5 × 10⁴A/cm² for the superconducting wire B have been obtained. During the experiments conducted thereafter, the critical current densities under the conditions of 10K in temperature and 1 T in magnetic field intensity have also been measured with the crystal grain sizes of the superconducting wires A and B being increased by increasing the synthesizing temperature of the superconductors and the heat-treating temperatures of both wires. As shown in Table 1, there has been observed the tendency that as the crystal grain size increases above 20 microns, the critical current density decreases. This is because, at the temperatures that the crystal grain size increases, the grain sizes in MgB₄ and in other non-identifiable non-superconducting phases also increase at the same time, and hereby because the current path is shut off. The above results clearly indicate that it is effective for the average crystal grain sizes of the superconductors in the superconducting wires to be reduced below 20 microns.

**Table 1**

| Average grain size (µm) | 8 | 11 | 14 | 17 | 20 | 23 | 26 | 29 | 32 | 35 |
|---|---|---|---|---|---|---|---|---|---|---|
| Critical current density in superconducting wire A (× 10⁴A/cm²) | 6.0 | 6.5 | 5.5 | 6.1 | 5.7 | 4.5 | 4.9 | 4.5 | 4.2 | 3.2 |
| Critical current density in superconducting wire B (× 10⁴A/cm²) | 5.7 | 6.0 | 5.8 | 5.7 | 6.1 | 4.8 | 4.5 | 4.2 | 4.1 | 3.6 |

Next, the densities of the superconductors in the wires have been examined to confirm that both densities are 90% of the respective theoretical densities. In order to clarify the relationships between critical current densities and actual densities relative to theoretical densities, wires with internal densities of 90% and 70% of the respective theoretical densities have been prepared and the magnetic field dependence of the respective critical current densities has been measured.

Fig. 3 is a diagram showing the relationship between critical current density and the intensity of the applied magnetic field. It has been found that compared with a wire 4 whose internal density is 90% of its theoretical value, a wire 5 whose internal density is 70% of its theoretical value exhibits critical current densities of 1/5 or less in a null magnetic field and in other magnetic fields, and hereby that the current density has dependence on the internal theoretical density of the wire. Numeral 4 in the figure denotes the magnetic field dependence of the critical current density of the superconducting wire whose density is 90% of its theoretical value, and numeral 5 denotes the magnetic field dependence of the critical current density of the superconducting wire whose density is 70% of its theoretical value.

During the experiments conducted thereafter, the densities of the superconductors in the wires have been varied and the resulting effects on the respective critical current densities have been examined. It has been verified that the electrical resistance values of both wires become zero at critical temperatures from 37.5 to 39.0K.

The above critical current densities have been measured at a temperature of 10K and a magnetic field intensity of 1T. Resultingly, as shown in Table 2, there has been observed the tendency that when the densities of the superconductors in the superconducting wires are 80% or less, the respective critical current densities decrease. These results clearly indicate that it is effective for the density of a superconductor to be increased above 80% of its theoretical density.

**Table 2**

| Ratio of actual density relative to theoretical density (%) | 60 | 65 | 70 | 75 | 80 | 85 | 90 |
|---|---|---|---|---|---|---|---|
| Critical current density in superconducting wire A (× 10⁴A/cm²) | 0.6 | 0.9 | 1.5 | 1.9 | 5.8 | 5.9 | 6.0 |
| Critical current density in superconducting wire B (× 10⁴A/cm²) | 0.2 | 1.1 | 1.5 | 2.3 | 5.8 | 6.2 | 6.1 |

In the present embodiment, an aluminum pipe h as been used as the metal-sheathing material having a superconductor charged therein. In the experiments conducted thereafter, however, various metallic pipes have been used to prepare wires in accordance with the processes shown in Fig. 1 and critical current density has been examined. The wires, after being prepared, have not been heat-treated. As a result, it has been found that critical current densities of 5.3-6.5 × 10⁴A/cm² can be obtained under the atmosphere of 10K in temperature and 1T in magnetic field intensity by using as the metal-sheathing material, either a single metal selected from a group consisting of gold, silver, aluminum, copper, iron, platinum, palladium, nickel, stainless steel, chromium, magnesium, tantalum, niobium, titanium, tin, beryllium, tungsten, and cobalt, or an alloy consisting of a plurality of metals selected from this group. The critical temperatures of these wires have also been measured with the direct-current four-terminal method to ensure that the electrical resistance values of all wires become zero at 35.5-39.5K. These results clearly indicate that it is effective to use, as the metal-sheathing material, either a single metal selected from a group consisting of gold, silver, aluminum, copper, iron, platinum, pall adium, nickel, stainless steel, chromium, magnesium, tantalum, niobium, titanium, tin, beryllium, tungsten, and cobalt, or an alloy consisting of a plurality of metals selected from this group.

As required, an intermediate layer may be provided between the metal-sheathing material and the superconductor. It is further preferable that this intermediate layer should include the element contained in the superconductor. For example, it is advisable to dispose MgO in the intermediate layer of a superconducting wire which contains MgB₂. Typical examples of intermediate layers include SrTiO₃ and hastelloy as well as MgO. However, an intermediate layer made up of whatever types of elements can be used, only if the quality of the superconductor is not deteriorated by the thermal reaction thereto.

We have also found that the addition of metal powder to the superconductor contained in the superconducting wire of the present invention is valid for improving critical current density. The validity is detailed below.

Magnesium powder (Mg: 99% pure) and amorphous boron powder (B: 99% pure) are used and then both types of powder, after being weighed for the atomic mole ratio between the magnesium and the boron to become 1:2, are mixed over 10 to 60 minutes. Next, the mixture that has thus been obtained is heat-treated over 2 to 10 hours at a temperature from 800 to 1,100 degrees C, and hereby, an MgB₂ superconductor is prepared. X-ray diffraction results on the obtained powder indicate that the content of the MgB₂ superconductor is more than 97.5% in terms of strength ratio. To obtain a single-phase superconductor, it is more effective to use fluoride as its raw material. Other special phases have included a slight amount of non-superconducting phase component not identifiable as MgB₄.

After that, metal powder consisting of either indium or lead alone or of both is weighed for a weight of 1% with respect to the weight percentage of the above-obtained superconducting powder, and then the superconducting powder and the metal powder are mixed over a time from 10 to 60 minutes. Next, the powder mixture that has thus been obtained is charged into a copper pipe which has a circular cross-sectional shape measuring 6.0 mm in outside diameter, 4.5 mm in inside diameter, and 500 mm in length. This wire material is then drawn at a cross-sectional area reduction ratio from 3% to 10%. The square wire 1 mm long and 2 mm wide, shown in Fig. 2, is the drawn wire. This wire was only diametrally reduced, and it was not heat-treated.

The critical temperatures of such wires as described above have been measured with the direct-current four-terminal method to ensure that the electrical resistance values of all wires become zero at 38-39K. The critical current densities under the conditions of 10K in temperature and 1 T in magnetic field intensity have also been measured to find that values from 7.1 × 10⁴ to 8.2 × 10⁴A/cm² can be obtained. After this, although the cross sections of the wires have been observed using a scanning electron microscope, it has not been able to find any added metal elements. Next, cross-sectional observations have been conducted using a transmission-type electron microscope, and it has been able to confirm that the metal elements exist at the crystal grain boundary of the superconductor. It is estimated, from this fact, that critical current density has improved because the added metal powder has improved intercrystalline bonding characteristics.

Also, the experiments conducted thereafter indicate that when either a single metal selected from a group consisting of gold, silver, magnesium, and aluminum, or a mixture consisting of a plurality of metals selected from this group is added as the element of the above-described metal powder together with indium or lead, critical current densities of 6.9-8.2 × 10⁴A/cm² can also be obtained under the atmosphere of 20K in temperature and 1T in magnetic field intensity.

However, since neither gold, silver, magnesium, nor aluminum is a metal whose fusion point is as low as that of the superconductor, none of the four metals is considered to be fused similarly to indium or lead. For this reason, each such metal has been cross-sectionally observed through a scanning electron microscope. Consequently, it has been able to confirm that these metals are present in the crystal grains and acting, although slightly, as pinning centers.

However, it has also been found that if the average crystal grain size of the superconductor is not greater than that of the metal powder added, no effects can be obtained and that there is more of a tendency for the critical temperature and the critical current density to decrease.

It follows from the above results that a superconducting wire high in critical current density can be obtained by adding to a superconductor, metal powder consisting of either a single metal selected from a group made up of indium, lead, gold, silver, magnesium, and aluminum, or a plurality of metals selected from this group. It has been made clear, however, that the average crystal grain size of the metal powder at this time must be smaller than the average crystal grain size of the superconductor.

Table 3 lists study results concerning the quantitative optimization of the metal powder to be added. During experiments, 0.001% to 75.000% of metal powder in terms of weight percentage with respect to a superconductor has been added and the critical current densities under the atmosphere of 10K in temperature and 1T in magnetic field intensity have been examined.

**Table 3**

| Adding ratio of metal powder (%) | 0.001 | 0.005 | 0.008 | 0.01 | 1 | 10 | 25 | 40 | 50 | 60 | 70 | 75 |
|---|---|---|---|---|---|---|---|---|---|---|---|---|
| Critical current density (× 10⁴A/cm²) | 7.5 | 7.4 | 6.9 | 7.0 | 6.9 | 7.4 | 7.3 | 7.2 | 7.1 | 3.5 | 3.2 | 1.2 |

As listed in Table 3, superconducting wires high in critical current density can be obtained by performing adjustments so that the amount of metal powder added becomes 50% or less of the superconductor in terms of weight percentage.

It has been proved that to obtain superconducting wires high in critical current density, it is valid to improve the intercrystalline bonding characteristics of the superconductor. Since adding low-fusion-point metal powder is effective for improving intercrystalline bonding characteristics, it has been studied whether the superconductor or the added metal powder can be fused during the manufacturing processes for the superconductor.

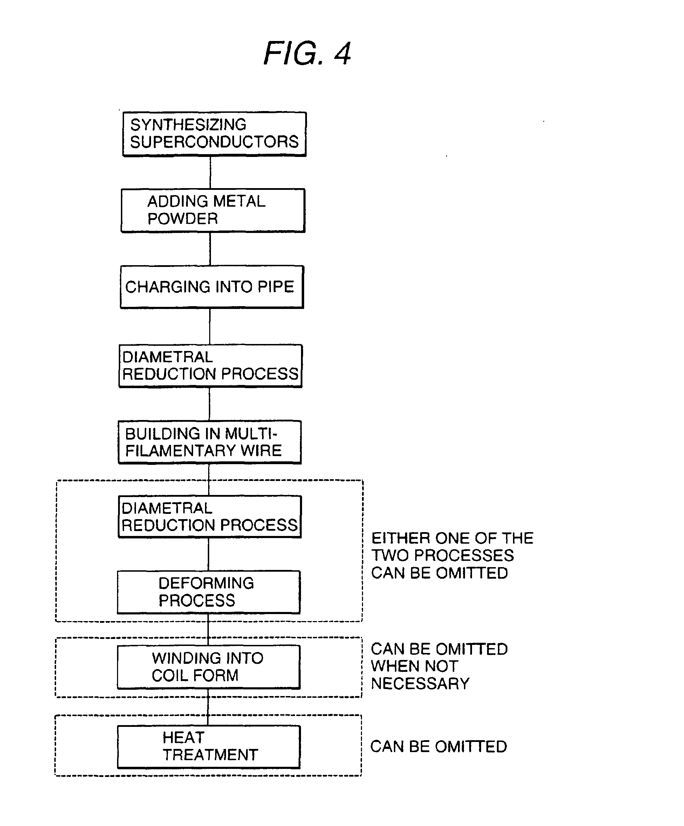

Fig. 4 is a process chart showing an example of such manufacturing processes. As a result, study results indicate that intercrystalline bonding characteristics improve during the diametral reduction process for the wire and the deforming process therefor.

After that, studies have been further performed on the optimum reduction ratio of the cross-sectional area during the diametral reduction and deforming processes, and on the optimum pressure during the deforming process. The results are shown in Tables 4 and 5. Measurements have been conducted under the atmosphere of 20K in temperature and 1T in magnetic fiel d intensity.

**Table 4**

| Cross-sectional area reduction ratio (%) | 0 | 2 | 5 | 7.5 | 10 | 15 | 20 |
|---|---|---|---|---|---|---|---|
| Critical current density (× 10⁴A/cm²) | 3.6 | 3.7 | 3.8 | 3.7 | 6.1 | 6.4 | 6.0 |

**Table 5**

| Pressure (ton/cm²) | 0 | 0.2 | 0.5 | 0.75 | 1.0 | 1.5 | 2.0 |
|---|---|---|---|---|---|---|---|
| Critical current density (× 10⁴A/cm²) | 3.1 | 3.7 | 3.4 | 3.8 | 6.5 | 6.4 | 6.4 |

The cross-sectional area reduction ratios in Table 4 are based on the shape of the superconductor charged into the metal-sheathing material. For example, if the superconductor is charged into a metallic pipe 6 mm in diameter, a cross-sectional area reduction ratio of 10% with respect to a 6-mm-diameter cross-sectional area (S = 9πmm²) will be achieved when the pipe is thinned down to 5.692 mm by a diametral reduction process. If the diameter during charging is 10 mm, the pipe needs to be thinned down to 9.487 mm by a diametral reduction process.

The pressures in Table 5 are ones applied to the surface when a deforming process is provided by, for example, rolling or uniaxial press machining. The results listed in the above tables clearly indicate that when diametral reduction takes place for a cross-sectional area reduction ratio of 10% or more, critical current density can be improved by applying a pressure of 1 ton/cm² during a deforming process. Experiments have been conducted thereafter to find that the simultaneous execution of the above-mentioned diametral reduction and deforming processes produces an even greater effect and that a maximum value of 7 × 10⁴A/cm² can be obtained.

After cross-sectional observation of a measured sample through a scanning electron microscope and a transmission-type electron microscope, it has been confirmed that when diametral reduction takes place for a cross-sectional area reduction ratio of 10% or more or when a pressure of 1 ton/cm² or more is applied during a deforming process, a portion of either the superconductor included in the superconducting wire or the added metal powder or portions of both the superconductor and the added metal powder are fused. Furthermore, a thermocouple has been directly mounted on the sample prior to the processes and the temperature of the sample has been measured during the processes. As a result, it has also been found that the temperature of the sample increases to a value at which a portion of either the superconductor or the added metal powder or portions of both begin to fuse during the processing of both.

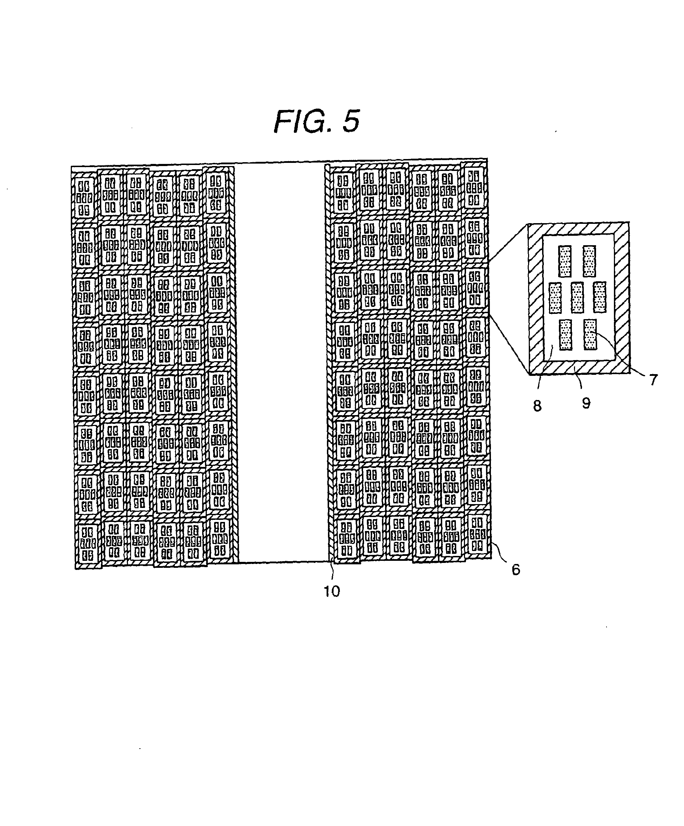

Fig. 5 shows an example of a cross-sectional schematic view of a coil which uses a superconducting wire of the present invention. A superconducting multi-filamentary superconducting wire 7 which has been prepared into a square shape measuring 1 mm thick and 2 mm wide, by use of the method embodying the present invention, is used as a solenoid-wound coil 6. Since this coil is a multi-filamentary wire, it has double-layer metal-sheathed structure, with its inner metal-sheathing material 8 being made of copper and its outer metal-sheathing material 9 being made of a nickel-based alloy. The coil measures 75 mm in inside diameter and 130 mm in outside diameter. A silver-based 1,000-ppm magnesium oxide diffusion-reinforcing alloy 74.5 mm in outside diameter and 2.0 mm in thickness is used as a winding bobbin 10 of the solenoid coil.

The nickel-based alloy that is the outer metal-sheathing material 9 is used as the insulating material and reinforcing material for this coil. Prior to winding, this insulating material is heat-treated to form an oxide film. In terms of characteristics, this insulating material is required to be excellent in mechanical strength, especially, mechanical tensile strength after heat treatment. This is due to the fact that the electromagnetic force exerted on the coil needs to be controlled. Electromagnetic force is roughly represented as the product between the intensity of the applied magnetic field, the coil current density, and the coil radius. Accordingly, under a strong magnetic field or when the shape of the coil is increased, the control of electromagnetic force becomes an important technical problem to be solved. For this reason, it is desirable that the electromagnetic force applied to the coil should be reinforced using an insulating material, and the characteristics required of the insulating material at this time include an insulating capability, excellent mechanical strength, the minimization of superconductor deterioration during heat treatment, and so on.

Such metallic materials as the nickel-based alloy used in the present embodiment, and a material that contains arms bronze (copper-aluminum alloy), are most preferable as the metals that satisfy these requirements. In the present embodiment, therefore, such nickel-based alloy as mentioned above is used as an insulating material 11 formed into a tape shape measuring 50 microns thick, 2 mm wide, and 500 m long. At this time, as described above, prior to winding, this insulating tape is heat-treated to form a fine-grained oxide film on its surface. Alternatively, a heat-resistant metallic material such as stainless steel can likewise be used, provided that an oxide film has been formed on the surface beforehand.

Such superconducting coil as shown in Fig. 5 can be further increased in strength by impregnating the entire coil with epoxy resin. The type of resin to be used in this case is not limited to epoxy resin. Alternatively, for example, resin that contains silicone, urethane, or the like, can be used.

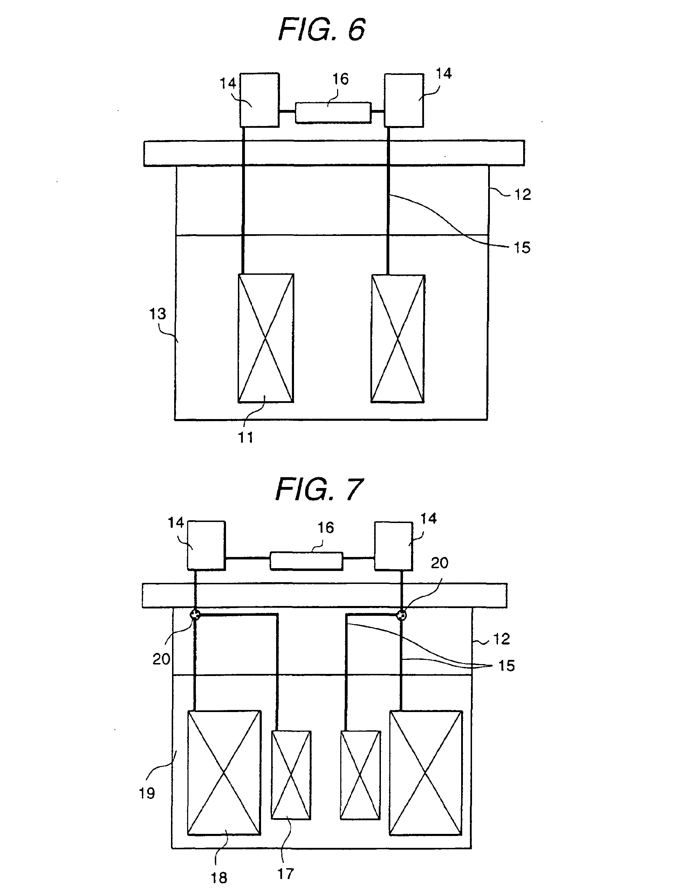

Fig. 6 shows an example of a configuration diagram of a superconducting magnet system according to the present invention. Both superconducting magnets 11 use a superconducting wire prepared in the present embodiment. The magnets 11 are installed in a cryostat 12 and cooled by liquid hydrogen 13. The superconducting magnets 11 are connected to a permanent current switch 16 via copper electrodes 14 and current leads 15.

In this configuration, the critical current defined by the current value existing when a specific resistance of 10⁻¹³ Ω m occurred across the superconducting magnet was 200 A, and the intensity of the magnetic field which occurred at this time was 3.8T. Also, when operation was changed to permanent current operation under this state, it was possible to maintain a 2.4-tesla magnetic field over 120 hours.

In this system, using oxide superconducting current leads, instead of the current leads 15, is effective for reducing the ingress of heat into the system and further makes it possible to suppress the attenuation of the permanent current due to resistance. Using an oxide superconductor in the permanent current switch also provides the advantage that a simplified system cooled by liquid nitrogen can be constructed.

Fig. 7 shows an example of a configuration diagram of a ferromagnetic-field-generating superconducting magnet system according to the present invention. Oxide-based superconducting magnets 17 and metal-based superconducting magnets 18 are used as the superconducting magnets in this system, wherein magnetic fields with a maximum intensity of 20T can be applied inside liquid helium 19. Each of these magnets is directly connected and this makes it necessary to connect different types of metal-based superconducting wires inside a cryostat 12. In the example of Fig. 7, oxide-based superconducting wires and metal-based superconducting wires need to be connected. At connections 20, three types of wires are connected in a crimped condition: the above-mentioned two types of superconducting wires and a superconducting wire prepared in the present embodiment.

In this configuration, although, during the conventional connection of, for example, an oxide-based superconducting wire and a metal-based superconducting wire, a resistance of 10⁻¹⁰ Ω has occurred, the resistance value has been reduced to 10⁻¹⁴ Ω by crimp-connecting both wires at the above connecting portion by use of a superconducting wire prepared in the present embodiment.

The oxide superconducting coil according to the present invention can be applied to a wide range of superconducting equipment, and the use of this coil in, for example, large-size magnets, nuclear magnetic resonance analyzing apparatus, magnetic resonance diagnosing apparatus for medical use, superconducting power storage units, magnetic separators, magnetic-field-applied single-crystal pull-up apparatus, refrigerator-cooled superconducting magnet apparatus, and the like, provides the effect that high equipment efficiency can be achieved.

### [Industrial Applicability]

As is obvious from the description given heretofore, a superconducting wire having a practical critical current density, and a superconducting magnet using the same can be obtained by applying the superconducting wire of the present invention, a method for manufacturing the same, and a superconducting magnet using the same.

## Claims

1. A superconducting wire having a boron-containing superconductor charged or included therein; wherein either a single metal selected from a group consisting of gold, silver, aluminum, copper, iron, platinum, palladium, nickel, stainless steel, chromium, magnesium, tantalum, niobium, titanium, tin, beryllium, tungsten, and cobalt, or an alloy consisting of a plurality of metals selected from this group, is disposed as a metal-sheathing material on the outer surface of said superconducting wire, the density of said superconducting wire after it has been finally processed is 80% or more of its theoretical density, and the critical temperature of said superconducting wire is 30K or more.

2. The superconducting wire according to Claim 1, wherein metal powder whose fusion point is lower than that of a superconductor included in said superconducting wire is added to said superconductor.

3. The superconducting wire according to Claim 2, wherein the element of said metal powder is a single metal selected from a group consisting of indium, lead, gold, silver, magnesium, and aluminum, or a mixture of a plurality of metals selected from this group.

4. A superconducting wire in which the relationship between the average crystal grain size, S, of the superconductor pertaining to Claim 1 or 2 and the average crystal grain size, M, of the metal powder according to Claim 2 or 3 is represented as S ≥ M.

5. The superconducting wire according to Claim 4, wherein the average crystal grain size of a superconductor is 20 microns or less.

6. A superconducting wire in which the amount of addition of the metal powder pertaining to either Claim 2, 3, or 4, is 50% or less of said superconductor in terms of weight percentage.

7. A method for manufacturing a superconducting wire, comprising; a first process in which superconductors that contain boron are to be synthesized into a single superconductor, a second process in which said superconductor that was prepared in said first process is to be charged into or included in a metal-sheathing material made of either a single metal selected from a group consisting of gold, silver, aluminum, copper, iron, platinum, palladium, nickel, stainless steel, chromium, magnesium, tantalum, niobium, titanium, tin, beryllium, tungsten, and cobalt, or an alloy consisting of a plurality of metals selected from this group, and either a third process in which a wire that was prepared in said second process is to be diametrally reduced for a cross-sectional area reduction ratio of at least 10% of its original value, or a fourth process in which said wire is to be deformed by applying a pressure of at least 1 ton/cm², or both of said third process and said fourth process.

8. The method for manufacturing a superconducting wire, defined in Claim 7, wherein temperature is increased to a region exceeding the temperature at which a portion of either the superconductor included in the superconducting wire or the metal powder added thereto, or portions of both the superconductor and the metal powder begin to fuse during said third process or said fourth process.

9. The method for manufacturing a superconducting wire, defined in Claim 7 or 8, wherein said superconducting wire is not provided with any heat-treating processes.

10. A method for manufacturing a superconducting wire, wherein fluoride is used as a raw material during the first process of Claim 7.

11. A superconducting magnet having a permanent current switch whose wires are wound into coil form by means of a superconducting wire which has been prepared using the method for manufacturing a superconducting wire, defined in either of Claims 7 to 10; with said superconducting magnet being configured so that the electrical resistance across said superconducting magnet is controlled to small enough a value for said superconducting magnet to function as a permanent current magnet.

12. The superconducting magnet of Claim 11, wherein, at the connections between different types of superconductors combined to form said superconducting magnet, said superconducting magnet is connected using a superconducting wire which has been prepared using the method for manufacturing a superconducting wire, defined in either of Claims 7 to 10.

13. The superconducting magnet of Claim 11 or 12, with the mechanical strength of said superconducting magnet being high enough for the hold of the electromagnetic force applied to said superconducting magnet.

14. The superconducting magnet according to either of Claims 11 to 13, wherein a single metal, or a plurality of metals, selected from a group consisting of either a copper alloy, stainless steel, titanium alloy, iron-based heat-resistant alloy, nickel-based heat-resistant alloy, and cobalt-based heat-resistant alloy that contains 0.1%-20.0% aluminum in terms of weight percentage, is used as said insulating material to be wound together with a superconducting wire.
